Europäisches Patentamt

(19) European Patent Office

Office européen des brevets

(11) Publication number: **0 201 300**
B1

# EUROPEAN PATENT SPECIFICATION

(12)

(45) Date of publication of the patent specification:
07.11.90

(21) Application number: **86303374.2**

(22) Date of filing: **02.05.86**

(51) Int. Cl.⁵: **H03K 17/78**, H03K 17/28, H02H 3/08

(54) **Electrical control arrangement.**

(30) Priority: **03.05.85 GB 8511290**

(43) Date of publication of application:
**17.12.86 Bulletin 86/46**

(45) Publication of the grant of the patent:
**07.11.90 Bulletin 90/45**

(84) Designated Contracting States:
**AT BE CH DE FR GB IT LI LU NL SE**

(56) References cited:
**DE-A- 2 051 701**
**US-A- 2 838 719**
**US-A- 3 432 786**
**US-A- 4 008 415**
**US-A- 4 167 721**

(73) Proprietor: **Yang, Tai-Her, 5-1 Taipin Street, Si-Hu Town Dzan-Hwa(TW)**

(72) Inventor: **Yang, Tai-Her, 5-1 Taipin Street, Si-Hu Town Dzan-Hwa(TW)**

(74) Representative: **Arthur, Bryan Edward et al, Withers & Rogers 4 Dyer's Buildings Holborn, London EC1N 2JT(GB)**

## Description

The present invention relates to an electrical control arrangement, and particularly to a switching and overload protection device suitable for an outdoor low voltage power supply system.

In such a system, damage may be caused to the transformer in the event of a short circuit during operation, such as when the wire is cut by a lawn mover or run over by a vehicle. To maintain the safety of the system, generally a thermal overload cut-out composed of a bi-metal plate with contact points at its end is usually added in series at the secondary side. When the bi-metal plate is heated by a current in excess of a rated value, the normally-closed contact points open when the metal plate cools again to a normal temperature the contacts close again.

It is know from DE-A-2 051 701 to provide a heating element adjacent to the thermal overload cut-out powered by a circuit controlled by a photocell is illuminated power is supplied to the heating element, causing the contents of the cut-out to remain open, and the system to remain switched off.

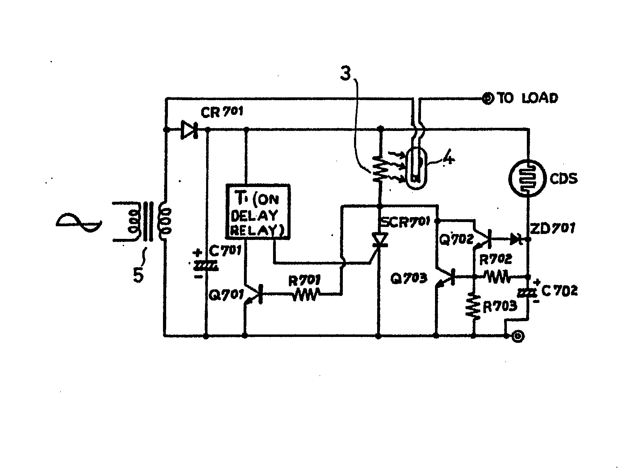

The invention, which is defined in the appended claims, provide an improved arrangement of this kind which will now be described with reference to the accompanying drawing.

Referring to the drawing, the device includes a transformer 5 which supplies the load terminals through a thermal overload cut-out 4. Adjacent to this is a heating element 3, the power to which is switched by an SCR701. A photocell CDS is connected in the input of a circuit comprising Zener-diode ZD701, transistor Q701, Q702 and Q703 and a delay timer T1 which controls the SCR701. The circuit is a d.c. circuit, powered from the transformer 5 via a retifier CR701 and a capacitor C701. Connected across the input of the circuit is a capacitor C702 which, in combination with the resistance of the photocell CDS and the input impedance, provides the input of the circuit with a long time constant.

The timer T1, is of the kind which resets to zero when power is off, and sends out a signal at a pre-set time after power on. It may be an analog or digited solid-state timer, or an electromechanical timer.

The operation of the circuit is as follows:

In daylight, the photocell CDS is continually illuminated. Once the pre-set time has elapsed, the timer T1 applies a voltage to the control-electrode of SCR701, causing it to conduct and energise the heating-element 3. The cut-out 4 opens, and remains open so long as CDS is illuminated.

When the CDS is not illuminated, it actuates Q701 and time switch T1, and the deactivates Q702 and Q703. The contact points on the thermal current breaker are closed again to resume the electrical load after its delayed cooling-off. The time switch sends out an electrical signal at specified time to actuate SCR701, warms up the heating element R702, activates the thermal cut-out and cuts off the current to Q701. When the CDS is illuminated again, actuates Q703, and the SCR701 which in parallel connection with Q703 turns off the electric current.

In case of overload or short circuit on the transmission line, the thermal current breaker CB turns off and on in a cyclic process to protect the power supply and the system.

The internal resistors of ZD701, C702 and CDC constitute a delay circuit, which enables C702 to slowly build up its voltage when it is illuminated with external light. The Q702 is actuated until C702 voltage exceeds ZD701 voltage, so as to preclude interference from temporary sporadic light from the outside.

## Claims

1. A switching and overload protection device for an outdoor low-tension illumination system comprising a transformer (5) for connection to the system, a thermal overload cut-out (4) connected in series between the transformer and the system and a photocell-circuit including a photocell (CDS) arranged to supply current to a heating-element (3) adjacent the thermal cut-out to cause the cut-out to remain open while the photocell is illuminated, characterised in that the photocell circuit includes a capacitor (C702), providing, in combination with the photocell, a time delay whereby the thermal cut-out is not caused to open on transient illumination of the photocell.

2. A switching and overload protection device according to claim 1 in which the photocell circuit further includes a delay device (T1) whose operator is initiated when the photocell ceases to be illuminated and which causes current to the heating element to be interrupted after a pre-set interval.

3. A switching and overload protection device according to claim 2 in which the photocell circuit comprises a circuit (ZD701, Q701, Q702, Q703) having the photocell and time delay capacitor connected at its input and having its output applied to the delay device to maintain it in a reset condition while the photocell is illuminated.

4. A switching and overload protection device according to claim 2 or claim 3 in which the output from the delay device (T1) is applied to an SCR (SCR 701) connected in series with the heating element.

## Patentansprüche

1. Eine Schalt- und Überlastschutzvorrichtung für ein Niederspannungs-Beleuchtungssystem im Freien mit einem Transformator (5) für die Verbindung mit dem System, einem thermischen Überlastausschalter (4), der in Reihe zwischen den Transformator und das System geschaltet ist, und einer lichtelektrischen Schaltung, die ein lichtelektrisches Bauteil (CDS) aufweist, das so angeordnet ist, daß Strom einem Heizelement (3) zugeführt wird, das in der Nähe des thermischen Ausschalters angeordnet ist, um zu bewirken, daß der Ausschalter geöffnet bleibt, während das lichtelektrische Bauteil beleuchtet ist, dadurch gekennzeichnet, daß die lichtelektrische Schaltung einen Kondensator (C 702) aufweist, der in Verbindung mit dem lichtelektrischen Bauteil eine Zeitverzögerung zur Verfügung stellt, wodurch der thermische Ausschalter bei einer vorübergehenden Beleuchtung des lichtelektrischen Bauteils nicht zum Öffnen gebracht wird.

2. Schalt- und Überlastschutzvorrichtung nach Anspruch 1, bei der die lichtelektrische Schaltung außerdem eine Verzögerungsvorrichtung (T 1) aufweist, deren Tätigkeit, wenn die Beleuchtung des lichtelektrischen Bauteils aufhört, in Gang gesetzt wird und die bewirkt, daß die Stromzufuhr zu dem Heizelement nach einem voreingestellten Zeitraum unterbrochen wird.

3. Schalt- und Überlastschutzvorrichtung nach Anspruch 2, bei der die lichtelektrische Schaltung einen Schaltungsteil (ZD 701, Q 701, Q 702, Q 703) besitzt, an dessen Eingang das lichtelektrische Bauteil und der Zeitverzögerungskondensator angeschlossen sind und dessen Ausgangssignal der Verzögerungsvorrichtung zugeführt wird, um diese in zurückgestelltem Zustand zu halten, während das lichtelektrische Bauteil beleuchtet ist.

4. Schalt- und Überlastschutzvorrichtung nach Anspruch 2 oder 3, bei der das Ausgangssignal der Verzögerungsvorrichtung (T 1) zu einem Thyristor (SCR 701) zugeführt wird, der mit dem Heizelement in Reihe geschaltet ist.

**Revendications**

1. Dispositif de commutation et de protection contre les surcharges pour un système d'éclairage basse tension destiné à l'extérieur, comprenant un transformateur (5) pour raccordement au système, un coupe-circuit thermique (4) contre les surcharges monté en série entre le transformateur et le système et un circuit photoélectrique comportant une cellule photoélectrique (CDS) disposée de manière à alimenter en courant un élément thermique (3) adjacent au coupe-circuit thermique pour permettre au coupe-circuit de rester ouvert lorsque la cellule photoélectrique est illuminée, caractérisé en ce que le circuit photoélectrique comprend un condensateur (C702) fournissant, en combinaison avec la cellule photoélectrique, une temporisation grâce à laquelle le coupe-circuit thermique ne peut être ouvert à la suite d'une illumination momentanée de la cellule photoélectrique.

2. Dispositif de commutation et de protection contre les surcharges selon la revendication 1, dans lequel le circuit photolectrique comprend en outre un dispositif de minuterie (T1) dont le fonctionnement est activé lorsque la cellule photoélectrique cesse d'être illuminée et qui permet au courant alimentant l'élémant thermique d'être interrompu après un intervalle donné.

3. Dispositif de commutation et de protection contre les surcharges selon la revendication 2, dans lequel le circuit photoélectrique comprend un circuit (ZD701, Q701, Q702, Q703) ayant la cellule photoélectrique et le condensateur de la minuterie reliés à son entrée, et dont la sortie est couplée au dispositif de minuterie pour le maintenir dans son état initial lorsque la cellule photoélectrique est illuminée.

4. Dispositif de commutation et de protection contre les surcharges selon la renvendication 2 ou la revendication 3, dans lequel la sortie du dispositif de minuterie (T1) est couplée à un thyristor au silicium (SCR701) monté en série avec l'élément thermique.